Europäisches Patentamt

European Patent Office

Office européen des brevets

(11) Veröffentlichungsnummer: **0 166 125**
A1

# EUROPÄISCHE PATENTANMELDUNG

(21) Anmeldenummer: 85105396.7

(22) Anmeldetag: 03.05.85

(51) Int. Cl.⁴: **H 03 K 17/945,** H 03 K 17/08, H 02 H 3/087

(30) Priorität: 30.05.84 DE 3420236

(43) Veröffentlichungstag der Anmeldung: 02.01.86 Patentblatt 86/1

(84) Benannte Vertragsstaaten: **AT BE CH DE FR GB IT LI LU NL SE**

(71) Anmelder: **i f m electronic gmbh, Teichstrasse 4, D-4300 Essen 1 (DE)**

(72) Erfinder: **Buck, Robert, Vogelherdbogen 67, D-7992 Tettnang (DE)**
Erfinder: **Lamarche, Jean-Luc, Dipl.-Ing., Zeppelinstrasse 1, D-7994 Langenargen (DE)**
Erfinder: **Schiff, Andreas, Dr., Haydnstrasse 48, D-7991 Eriskirch (DE)**
Erfinder: **Spähn, Peter, Birkensteige 24, D-7992 Tettnang (DE)**

(74) Vertreter: **Gesthuysen, Hans Dieter, Dipl.-Ing. et al, Patentanwälte Gesthuysen + von Rohr Huyssenallee 15 Postfach 10 13 33, D-4300 Essen 1 (DE)**

(54) Elektronisches, vorzugsweise berührungslos arbeitendes Schaltgerät.

(57) Dargestellt und beschrieben ist ein elektronisches, berührungslos arbeitendes Schaltgerät, mit einem von außen beeinflußbaren Anwesenheitsindikator, z.B. einem Oszillator, mit einem von dem Anwesenheitsindikator über einen Schaltverstärker steuerbaren elektronischen Schalter (1), nämlich einem Transistor, und mit einem Überlastungs- und Kurzschlußschutz (2), wobei ein in Reihe mit dem elektronischen Schalter (1) liegender Ansprechwiderstand (3) und ein parallel zum Ansprechwiderstand (3) liegendes Verzögerungsglied (4) – Reihenschaltung aus einem Verzögerungswiderstand (5) und einem Verzögerungskondensator (6) – vorgesehen ist und der elektronische Schalter (1) nach einer durch das Verzögerungsglied (4) vorgegebenen Verzögerungszeit abschaltet, wenn der über den elektronischen Schalter (1) und über den Ansprechwiderstand (3) fließende Laststrom größer ist als ein vorgegebener Ansprechstrom.

Bei dem dargestellten elektronischen Schaltgerät wird dadurch qualitativ zwischen einer Überlastung und einem Kurzschluß differenziert, daß ein nicht dem Kurzschlußschutz dienender Überlastungsschutz und ein nicht dem Überlastungsschutz dienender Kurzschlußschutz vorgesehen sind.

Die Erfindung betrifft ein elektronisches, vorzugsweise berührungslos
arbeitendes Schaltgerät, mit einem von außen beeinflußbaren Anwesenheitsindikator, z. B. einem Oszillator, mit einem von dem Anwesenheitsindikator - ggf. über einen Schaltverstärker - steuerbaren elektronischen
Schalter, z. B. einem Transistor, einem Thyristor oder einem Triac, und
mit einem Überlastungs- und Kurzschlußschutz, wobei ein in Reihe mit
dem elektronischen Schalter liegender Ansprechwiderstand und ein parallel
zum Ansprechwiderstand liegendes Verzögerungsglied - Reihenschaltung aus
einem Verzögerungswiderstand und einem Verzögerungskondensator - vorgesehen ist und der elektronische Schalter nach einer durch das Verzögerungsglied vorgegebenen Verzögerungszeit abschaltet, wenn der über den
elektronischen Schalter und über den Ansprechwiderstand fließende Laststrom größer ist als ein vorgegebener Ansprechstrom.

Elektronische Schaltgeräte der zuvor beschriebenen Art sind kontaktlos
ausgeführt und werden in zunehmendem Maße anstelle von elektrischen,
mechanisch betätigten Schaltgeräten, die kontaktbehaftet ausgeführt
sind, in elektrischen Meß-, Steuer- und Regelkreisen verwendet. Das
gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für
das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem
Anwesenheitsindikator hinreichend weit genähert, so steuert der Anwesenheitsindikator den elektronischen Schalter um, d. h. bei einem als Schliesser ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine
physikalische Größe eines Beeinflussungsmediums, für die das Schaltgerät sensitiv ist, einen entsprechenden Wert erreicht hat.)

- 1 -

Wesentlicher Bestandteil von elektronischen Schaltgeräten der zuvor beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 733, 26 28 427, 27 11 877 und 27 44 785). Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Bei induktiven Annäherungsschaltern gilt für den Oszillator, solange ein Metallteil einen vorgegebenen Abstand noch nicht erreicht hat, $K \cdot V = 1$ mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß $K \cdot V > 1$ wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V > 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß $K \cdot V = 1$ wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

- 2 -

Optoelektronische Annäherungsschalter weisen einen Lichtsender und einen
Lichtempfänger auf und werden auch als Lichtschranken bezeichnet. Dabei
unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem
der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden
Lichtstrahl zum Lichtempfänger zurückreflektiert. In beiden Fällen
spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es
gibt jedoch auch Lichtschranken des zuletzt beschriebenen Lichtschrankentyps, bei dem der vom Lichtsender kommende Lichtstrahl nur durch ein
entsprechendes Beeinflussungselement zum Lichtempfänger zurückreflektiert wird.

Elektronische, berührungslos arbeitende Schaltgeräte sind anfangs mit
einer Reihe von Problemen behaftet gewesen, - gemessen an elektrischen,
mechanisch betätigten Schaltgeräten -, nämlich u. a. mit den Problemen
"Erzeugung einer Speisespannung für den Oszillator", "Ausbildung des
Oszillators", "Einschaltimpulsverhinderung". Mit diesen Problemen und
deren Lösungen (und mit anderen, bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213,
20 36 840, 21 27 956, 22 03 038, 22 03 039, 22 03 040, 22 03 906,
23 30 233, 23 31 732, 23 56 490, 26 13 423, 26 16 265, 26 16 773,
26 28 427, 27 11 877, 27 44 785, 29 43 911, 30 04 829, 30 38 102,
30 38 141 und 30 38 692.

Im übrigen tritt bei elektronischen Schaltgeräten ein Problem auf, das
bei elektrischen, also kontaktbehafteten Schaltgeräten weitgehend gelöst

- 3 -

ist, nämlich das Problem des Überlastungs- und Kurzschlußschutzes. Das Problem des Überlastungs- und Kurzschlußschutzes ist bei elektrischen, kontaktbehafteten Schaltgeräten in einfacher Weise dadurch gelöst, daß entweder diesen Schaltgeräten Sicherungen vorgeschaltet sind, die bei einer Überlastung bzw. bei einem Kurzschluß ansprechen, oder daß diese Schaltgeräte selbst mit z. B. elektromagnetischen Überlastungs- und Kurzschlußauslösern ausgerüstet sind.

Das zuvor angesprochene Problem des Überlastungs- und Kurzschlußschutzes tritt auch dann auf, wenn es sich nicht um ein elektronisches Schaltgerät, sondern um einen elektronischen, analog arbeitenden Meßwertumformer handelt. Ein solcher Meßwertumformer kann z. B. ausgangsseitig einen Transistor haben, der nicht nur die dualen Zustände "durchgeschaltet" und "gesperrt" darstellen kann, sondern vielmehr eine der von dem Anwesenheitsindikator aufgenommenen Information analoge Ausgangsgröße realisiert.

Elektronische Schaltgeräte der eingangs beschriebenen Art, also solche, die einen Überlastungs- und Kurzschlußschutz haben, gehören ebenfalls bereits zum Stand der Technik (vgl. die DE-OSen 21 49 063, 23 31 732 und 25 15 654). Dabei ist allen bekannten elektronischen Schaltgeräten mit einem Überlastungs- und Kurzschlußschutz gemeinsam, daß nicht qualitativ zwischen einer Überlastung und einem Kurzschluß differenziert wird; ein Kurzschluß wird nur als etwas quantitativ anderes als eine Überlastung gesehen, nämlich als eine besonders hohe Überlastung.

Der Erfindung liegt nun die Aufgabe zugrunde, das elektronische Schaltgerät, von dem die Erfindung ausgeht, so auszugestalten und weiterzubilden, daß dabei qualitativ zwischen einer Überlastung und einem Kurzschluß differenziert wird.

Das erfindungsgemäße elektronische Schaltgerät ist nun zunächst und im wesentlichen dadurch gekennzeichnet, daß ein nicht dem Kurzschlußschutz

- 4 -

dienender Überlastungsschutz und ein nicht dem Überlastungsschutz dienender Kurzschlußschutz vorgesehen sind. Dabei meint "ein nicht dem Kurzschlußschutz dienender Überlastungsschutz" einen Überlastungsschutz, der auf einen relativ hohen Überlastungsstrom = Kurzschlußstrom mit einer relativ kurzen Überlastungszeit = Kurzschlußzeit nicht anspricht, und "ein nicht dem Überlastungsschutz dienender Kurzschlußschutz" einen Kurzschlußschutz, der auf einen unter einem relativ hohen Ansprechstrom liegenden Überlastungsstrom nicht anspricht.

Im folgenden werden der Ausgangspunkt der Erfindung, die der Erfindung zugrundeliegende Problematik, die Lehre der Erfindung sowie Ausgestaltungen und Weiterbildungen der Lehre der Erfindung anhand von zeichnerisch dargestellten Ausführungsbeispielen näher erläutert; es zeigt

Fig. 1     einen Ausschnitt aus einem Schaltbild eines zum Stand der Technik gehörenden elektronischen, berührungslos arbeitenden Schaltgerätes,

Fig. 2     einen Ausschnitt aus einem Schaltbild einer ersten Ausführungsform eines erfindungsgemäßen elektronischen, berührungslos arbeitenden Schaltgerätes,

Fig. 3     einen Ausschnitt aus einem Schaltbild einer zweiten Ausführungsform eines erfindungsgemäßen elektronischen, berührungslos arbeitenden Schaltgerätes und

Fig. 4     einen Ausschnitt aus einem Schaltbild einer dritten Ausführungsform eines erfindungsgemäßen elektronischen, berührungslos arbeitenden Schaltgerätes.

Zu den in den Figuren dargestellten elektronischen, berührungslos arbeitenden Schaltgeräten gehören ein - nicht dargestellter - von außen beeinflußbarer Anwesenheitsindikator, z. B. ein Oszillator, ein - nicht

- 5 -

dargestellter - Schaltverstärker, der dem Anwesenheitsindikator nachgeschaltet ist, ein von dem Anwesenheitsindikator über den Schaltverstärker steuerbarer elektronischer Schalter 1, in den dargestellten Ausführungsbeispielen ein Transistor, und ein Überlastungs- und Kurzschlußschutz 2. Dabei ist ein in Reihe mit dem elektronischen Schalter 1 liegender Ansprechwiderstand 3 und ein parallel zum Ansprechwiderstand 3
liegendes Verzögerungsglied 4 - Reihenschaltung aus einem Verzögerungswiderstand 5 und einem Verzögerungskondensator 6 - vorgesehen und schaltet der elektronische Schalter 1 nach einer durch das Verzögerungsglied 4 vorgegebenen Verzögerungszeit ab, wenn der über den elektronischen Schalter 1 und über den Ansprechwiderstand 3 fließende Laststrom größer ist als ein vorgegebener Ansprechstrom.

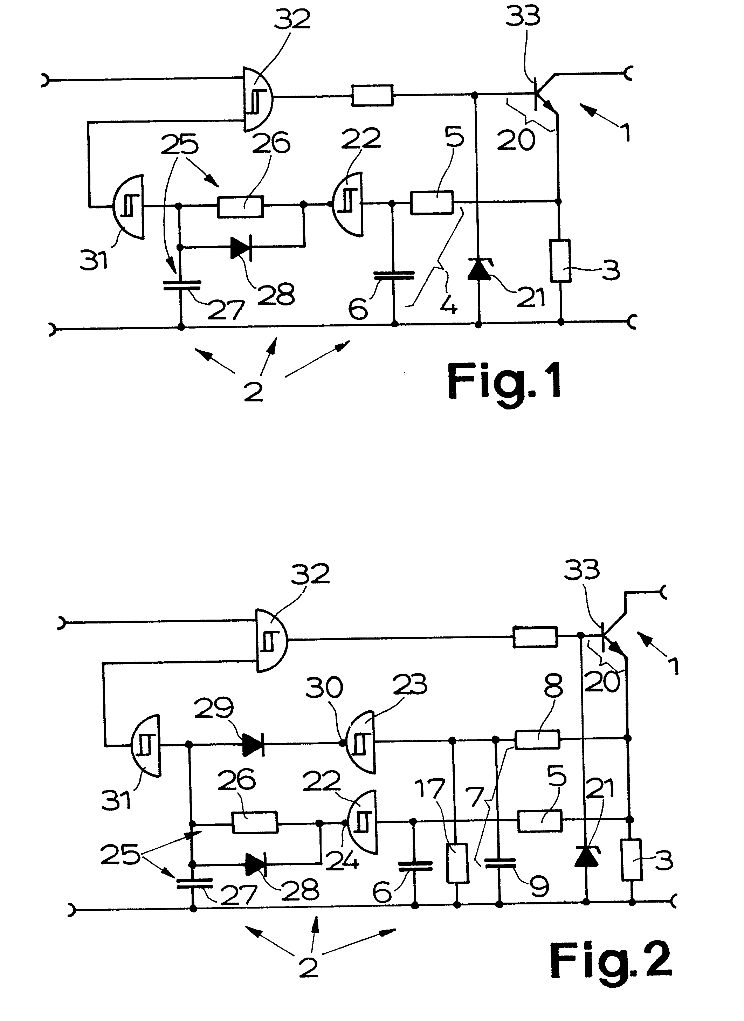

Bei dem im Stand der Technik bekannten elektronischen Schaltgerät - Fig. 1 -
wird nicht qualitativ zwischen einer Überlastung und einem Kurzschluß
differenziert; ein Kurzschluß wird nur als etwas quantitativ anderes
als eine Überlastung gesehen, nämlich als eine besonders hohe Überlastung. Es besteht eine Abhängigkeit zwischen dem Überlastungsstrom
und der Verzögerungszeit, also der Ansprechzeit des Überlastungs- und
Kurzschlußschutzes 2; je größer der Überlastungsstrom ist, desto kürzer
ist die Ansprechzeit.

Nun werden elektronische Schaltgeräte der hier in Rede stehenden Art
auch dort eingesetzt, wo beim Einschalten kurzzeitig, z. B. für ca.
20 ms, ein Überlastungsstrom fließt, der z. B. gleich dem fünffachen
des Nennstroms sein kann. Also darf dann der Überlastungs- und Kurzschlußschutz 2 noch nicht ansprechen. Eine entsprechende Auslegung
von Ansprechwiderstand 3 und Verzögerungsglied 4 bei dem bekannten
elektronischen Schaltgerät - Fig. 1 - führt zu Problemen:

Bei einem elektronischen Schaltgerät mit einer maximalen Betriebsspannung von 250 V und einem Nennstrom von 400 mA soll der Ansprechwiderstand 3 und das Verzögerungsglied 4 so ausgelegt sein, daß ein während

- 6 -

einer zulässigen Überlastungszeit von 20 ms fließender zulässiger Überlastungsstrom von 2 A nicht dazu führt, daß der Überlastungs- und Kurzschlußschutz 2 anspricht. Dann wird bei einem Kurzschluß, wenn der
Kurzschlußstrom auf 2 A begrenzt ist, am elektronischen Schalter 1 eine
unzulässig große elektrische Arbeit von 10 Ws in Wärme umgesetzt. (Die
elektrische Arbeit, die am elektronischen Schalter 1 in Wärme umgesetzt
wird, ist das Integral des Produktes aus der Spannung am elektronischen
Schalter 1 und aus dem Strom über den elektronischen Schalter 1 über
der zulässigen Überlastungszeit.)

Erfindungsgemäß sind nun ein nicht dem Kurzschlußschutz dienender Überlastungsschutz und ein nicht dem Überlastungsschutz dienender Kurzschlußschutz vorgesehen.

Wie bereits mehrfach ausgeführt, wird im Stand der Technik - Fig. 1 -
nicht qualitativ zwischen einer Überlastung und einem Kurzschluß differenziert. Häufig wird bei den im Stand der Technik bekannten elektronischen Schaltgeräten auch quantitativ nicht zwischen einer Überlastung
und einem Kurzschluß differenziert, nämlich dann nicht, wenn der Kurzschlußstrom elektronisch so begrenzt wird, daß er nicht - oder kaum -
größer werden kann als der Überlastungsstrom, bei dem der Überlastungs-
und Kurzschlußschutz 2 anspricht.

Demgegenüber wird bei dem erfindungsgemäßen elektronischen Schaltgerät dadurch, daß ein nicht den Kurzschlußschutz dienender Überlastungsschutz und ein nicht dem Überlastungsschutz dienender Kurzschlußschutz
vorgesehen sind, qualitativ differenziert zwischen einer Überlastung
und einem Kurzschluß.

Bei dem erfindungsgemäßen elektronischen Schaltgerät - Fig. 2 bis 4 -
ist das Verzögerungsglied 4 so dimensioniert, daß ein während einer
zulässigen Überlastungszeit, z. B. 20 ms, fließender zulässiger Überlastungsstrom, z. B. gleich dem fünffachen des Nennstroms, nicht zum

- 7 -

Abschalten des elektronischen Schalters führt, - eine Dimensionierung, die bei dem im Stand der Technik bekannten elektronischen Schaltgerät - Fig. 1 - zu einer unzulässig hohen Belastung des elektronischen Schalters 1 führen würde.

Im Ausführungsbeispiel nach Fig. 2 besteht der Kurzschlußschutz aus dem Ansprechwiderstand 3 und einem parallel zum Ansprechwiderstand 3 liegenden zweiten Verzögerungsglied 7 - Reihenschaltung aus einem zweiten Verzögerungswiderstand 8 und einem zweiten Verzögerungskondensator 9. Die Verzögerungszeit des zweiten Verzögerungsgliedes 7 ist klein gegenüber der Verzögerungszeit des ersten Verzögerungsgliedes 4. Während der Überlastungsschutz - Ansprechwiderstand 3 und Verzögerungsglied 4 - dann und nur dann anspricht, wenn über eine zulässige Überlastungszeit hinaus ein hinreichend großer Laststrom - Laststrom größer als ein vorgegebener Ansprechstrom = Überlastungsstrom - fließt, spricht der Kurzschlußschutz - mit einer relativ kurzen Verzögerungszeit - an, wenn der Laststrom größer ist als ein zulässiger Überlastungsstrom. Bei dieser Ausführungsform des erfindungsgemäßen elektronischen Schaltgerätes wird also dann und nur dann ein Betriebszustand als Kurzschluß gewertet und spricht dann und nur dann der Kurzschlußschutz an, wenn der Laststrom größer ist als ein zulässiger Überlastungsstrom.

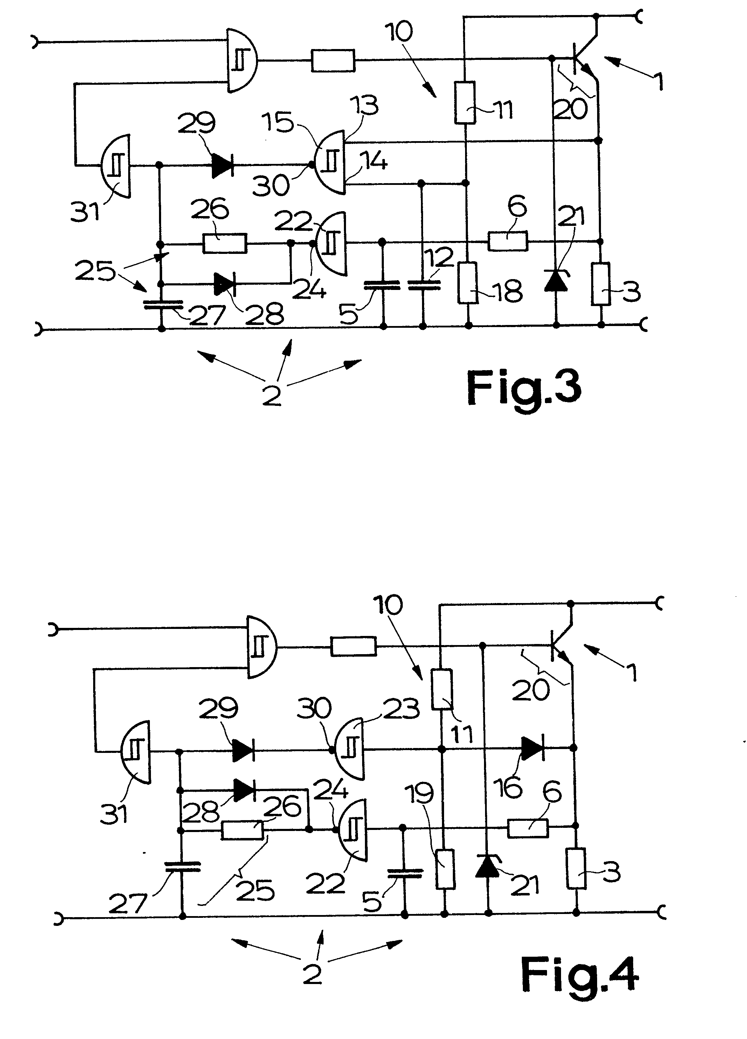

In den Ausführungsbeispielen nach den Fig. 3 und 4 besteht der Kurzschlußschutz aus dem Ansprechwiderstand 3 und einem parallel zum elektronischen Schalter 1 liegenden Spannungsindikator 10. Während wiederum der Überlastungsschutz - Ansprechwiderstand 3 und Verzögerungsglied 4 - dann und nur dann anspricht, wenn über eine zulässige Überlastungszeit hinaus ein hinreichend großer Laststrom fließt, spricht der Kurzschlußschutz an, wenn ein hinreichend großer Laststrom - Laststrom größer als ein vorgegebener Ansprechstrom - fließt und die Spannung am elektronischen Schalter 1 größer ist als eine vorgegebene Ansprechspannung. Bei dieser Ausführungsform wird also dann und nur dann ein Betriebszustand als Kurzschluß gewertet und spricht dann und nur dann der Kurz-

- 8 -

schlußschutz an, wenn der Laststrom größer ist als ein vorgegebener Ansprechstrom und die Spannung am elektronischen Schalter 1 größer ist als eine vorgegebene Ansprechspannung.

Bei der zuletzt beschriebenen Ausführungsform des erfindungsgemäßen elektronischen Schaltgerätes - Fig. 3 und 4 - wird als Kurzschluß also nicht eine größere Überlastung angesehen, sondern eine Überlastung bei einer über einer Ansprechspannung liegenden Spannung am elektronischen Schalter 1. Diese Lehre der Erfindung, der ganz besondere Bedeutung zukommt, geht von folgenden möglichen Betriebszuständen aus:

a) Gesperrter elektronischer Schalter 1. Es fließt kein Laststrom. Die Spannung am elektronischen Schalter 1 ist die Betriebsspannung; sie liegt über einer vorgegebenen Ansprechspannung.

b) Leitender elektronischer Schalter 1. Es fließt ein unter dem Ansprechstrom liegender Laststrom. Die Spannung am elektronischen Schalter 1 ist sehr gering; sie liegt unter einer vorgegebenen Ansprechspannung.

c) Leitender elektronischer Schalter 1. Es fließt ein über dem Ansprechstrom liegender Laststrom. Die Spannung am elektronischen Schalter 1 ist sehr gering; sie liegt unter einer vorgegebenen Ansprechspannung.

d) Leitender elektronischer Schalter 1. Es fließt ein über dem Ansprechstrom liegender Laststrom. Die Spannung am elektronischen Schalter 1 ist - zumindest annähernd - die Betriebsspannung; sie liegt über einer vorgegebenen Ansprechspannung.

Die Betriebszustände a) und b) sind normale Betriebszustände, - der Betriebszustand a) der Betriebszustand "Schaltgerät sperrend" und der Betriebszustand b) der Betriebszustand "Schaltgerät leitend".

- 9 -

Demgegenüber handelt es sich bei den Betriebszuständen c) und d) um fehlerhafte Betriebszustände, - beim Betriebszustand c) um den Betriebszustand "Schaltgerät leitend, Überlastung", beim Betriebszustand d) um den Betriebszustand "Schaltgerät leitend, Kurzschluß". Beim Betriebszustand c) spricht der Überlastungsschutz an, wenn der Laststrom länger als die zulässige Überlastungzeit größer ist als der Ansprechstrom. Der Kurzschlußschutz spricht nicht an, weil die Spannung am elektronischen Schalter 1 unter der Ansprechspannung liegt. Beim Betriebszustand d) spricht der Kurzschlußschutz an, weil der Laststrom größer ist als der Ansprechstrom und die Spannung am elektronischen Schalter 1 größer ist als die vorgegebene Ansprechspannung.

Aus den vorangegangenen Ausführungen ist ableitbar, daß die zuletzt beschriebene Ausführungsform des erfindungsgemäßen elektronischen Schaltgerätes es auch möglich macht, den Kurzschlußschutz bei einem Ansprechstrom ansprechen zu lassen, der unterhalb des maximal zulässigen Überlastungsstroms liegt.

Im übrigen gibt es verschiedene Möglichkeiten, die zuletzt beschriebene Ausführungsform eines erfindungsgemäßen elektronischen Schaltgerätes konkret zu realisieren.

Im Ausführungsbeispiel nach Fig. 3 besteht der Spannungsindikator 10 aus einem Spannungsindikatorwiderstand 11 und einem in Reihe mit dem Spannungsindikatorwiderstand 11 liegenden Spannungsindikatorkondensator 12. Im übrigen sind dabei der Ansprechwiderstand 3 und der Spannungsindikator 10 an die Eingänge 13, 14 eines UND-Gliedes 15 angeschlossen. Bei dieser Ausführungsform, bei der den Eingängen 13, 14 des UND-Gliedes 15 jeweils, wie in Fig. 3 angedeutet, ein Schmitt-Trigger nachgeschaltet sein kann, werden also die beiden für das Ansprechen des Kurzschlußschutzes erforderlichen Kriterien "Laststrom größer als der Ansprechstrom" und "Spannung am elektronischen Schalter 1 größer als die Ansprechspannung" durch das UND-Glied 15 verknüpft.

- 10 -

Dieser Verknüpfung, Undierung, dient im Ausführungsbeispiel nach Fig. 4 eine zwischen dem Ansprechwiderstand 3 und dem Spannungsindikator 10 in Sperrichtung geschaltete Koppeldiode 16.

Im übrigen ist in den in den Fig. 2 bis 4 dargestellten Ausführungsbeispielen eines erfindungsgemäßen elektronischen Schaltgerätes jeweils ein Potentialausgangswiderstand 17 bzw. 18 bzw. 19 vorgesehen. Im Ausführungsbeispiel nach Fig. 2 liegt der Potentialausgangswiderstand 17 parallel zum zweiten Verzögerungskondensator 9. Im Ausführungsbeispiel nach Fig. 3 ist der Potentialausgangswiderstand 18 dem Spannungsindikatorkondensator 12 parallelgeschaltet. Für das Ausführungsbeispiel nach Fig. 4 gilt schließlich, daß der Potentialausgangswiderstand 19 in Reihe mit dem Spannungsindikatorwiderstand 11 geschaltet ist.

Bei den in den Fig. 2 bis 4 dargestellten Ausführungsbeispielen von erfindungsgemäßen elektronischen Schaltgeräten sind auch Maßnahmen verwirklicht, die auch bei dem in Fig. 1 dargestellten, im Stand der Technik bekannten elektronischen Schaltgerät verwirklicht sind.

Zunächst ist in allen Ausführungsbeispielen eines erfindungsgemäßen elektronischen Schaltgerätes als elektronischer Schalter 1 ein Transistor vorgesehen und liegt der Ansprechwiderstand 3 im Emitterkreis des elektronischen Schalters 1. Dabei ist der Reihenschaltung aus der Basis-Emitter-Strecke 20 des elektronischen Schalters 1 und aus dem Ansprechwiderstand 3 eine Zenerdiode 21 parallelgeschaltet, die den Laststrom insgesamt begrenzt. Die Zenerspannung der Zenerdiode 21, der Spannungsabfall an der Basis-Emitter-Strecke 20 des elektronischen Schalters 1 und der Ansprechwiderstand 3 begrenzen in üblicher Weise den Laststrom.

Wie die Fig. 2 bis 4 zeigen, sind dem Überlastungsschutz und dem Kurzschlußschutz jeweils ein invertierender Schmitt-Trigger 22, 23 (Fig. 2), 22 und Bestandteil des UND-Gliedes 15 (Fig. 3), 22, 23 (Fig. 4) nach-

- 11 -

geschaltet. An den Ausgang 24 des dem Überlastungsschutz nachgeschalteten Schmitt-Triggers 22 ist ein drittes Verzögerungsglied 25 - Reihenschaltung aus einem dritten Verzögerungswiderstand 26 und einem dritten Verzögerungskondensator 27 - angeschlossen. Der dritter Verzögerungskondensator 27 ist über jeweils eine in Durchlaßrichtung geschaltete Entladediode 28, 29 mit den Ausgängen 24, 30 der beiden Schmitt-Trigger 22, 23 (Fig. 2), des Schmitt-Triggers 22 und des UND-Gliedes 15 (Fig. 3) bzw. der Schmitt-Trigger 22, 23 verbunden. Es sind also Ausführungsbeispiele von elektronischen Schaltgeräten dargestellt, bei denen nach einem Ansprechen des Überlastungsschutzes bzw. des Kurzschlußschutzes der elektronische Schalter 1 immer wieder durchgeschaltet wird, und zwar mit einer Wiederholfrequenz, die durch das dritter Verzögerungsglied 25 bestimmt ist.

Schließlich zeigen die Fig. 1 bis 4 Ausführungsbeispiele von elektronischen Schaltgeräten, bei denen dem dritten Verzögerungskondensator 27 ein Schmitt-Trigger 31 nachgeschaltet ist, der Anwesenheitsindikator bzw. der dem Anwesenheitsindikator nachgeschaltete Schaltverstärker einerseits und der dem dritten Verzögerungskondensator 27 nachgeschaltete Schmitt-Trigger 31 andererseits über ein UND-Glied 32 an die Steuerelektrode 33 des elektronischen Schalters 1 angeschlossen sind, und zwar über einen Ansteuerwiderstand 34, und den Eingängen 35, 36 des UND-Gliedes 32 jeweils ein Schmitt-Trigger nachgeschaltet ist.

- 12 -

Patentansprüche:

1. Elektronisches, vorzugsweise berührungslos arbeitendes Schaltgerät, mit einem von außen beeinflußbaren Anwesenheitsindikator, z. B. einem Oszillator, mit einem von dem Anwesenheitsindikator - ggf. über einen Schaltverstärker - steuerbaren elektronischen Schalter, z. B. einem Transistor, einem Thyristor oder einem Triac, und mit einem Überlastungs- und Kurzschlußschutz, wobei ein in Reihe mit dem elektronischen Schalter liegender Ansprechwiderstand und ein parallel zum Ansprechwiderstand liegendes Verzögerungsglied - Reihenschaltung aus einem Verzögerungswiderstand und einem Verzögerungskondensator - vorgesehen ist und der elektronische Schalter nach einer durch das Verzögerungsglied vorgegebenen Verzögerungszeit abschaltet, wenn der über den elektronischen Schalter und über den Ansprechwiderstand fließende Laststrom größer ist als ein vorgegebener Ansprechstrom, d a d u r c h g e k e n n z e i c h n e t, daß ein nicht dem Kurzschlußschutz dienender Überlastungsschutz und ein nicht dem Überlastungsschutz dienender Kurzschlußschutz vorgesehen sind.

2. Elektronisches Schaltgerät nach Anspruch 1, dadurch gekennzeichnet, daß das Verzögerungsglied (4) so dimensioniert ist, daß ein während einer zulässigen Überlastungszeit, z. B. 20 ms, fließender zulässiger Überlastungsstrom, z. B. gleich dem Fünffachen des Nennstroms, nicht zum Abschalten des elektronischen Schalters (1) führt.

3. Elektronisches Schaltgerät nach Anspruch 1 oder 2, dadurch gekennzeichnet, daß der Kurzschlußschutz aus dem Ansprechwiderstand (3) und einem parallel zum Ansprechwiderstand (3) liegenden zweiten Verzögerungsglied (7) - Reihenschaltung aus einem zweiten Verzögerungswiderstand (8) und einem zweiten Verzögerungskondensator (9) - besteht.

- 1 -

4. Elektronisches Schaltgerät nach Anspruch 3, dadurch gekennzeichnet, daß die Verzögerungszeit des zweiten Verzögerungsgliedes (7) klein ist gegenüber der Verzögerungszeit des ersten Verzögerungsgliedes (4).

5. Elektronisches Schaltgerät nach Anspruch 1 oder 2, dadurch gekennzeichnet, daß der Kurzschlußschutz aus dem Ansprechwiderstand (3) und einem parallel zum elektronischen Schalter (1) liegenden Spannungsindikator (10) besteht.

6. Elektronisches Schaltgerät nach Anspruch 5, dadurch gekennzeichnet, daß der Spannungsindikator (10) aus einem Spannungsindikatorwiderstand (11) und ggf. einem in Reihe mit dem Spannungsindikatorwiderstand (11) liegenden Spannungsindikatorkondensator (12) besteht.

7. Elektronisches Schaltgerät nach Anspruch 5 oder 6, dadurch gekennzeichnet, daß der Ansprechwiderstand (3) und der Spannungsindikator (10) an die Eingänge (13, 14) eines UND-Gliedes (15) angeschlossen sind.

8. Elektronisches Schaltgerät nach Anspruch 5 oder 6, dadurch gekennzeichnet, daß zwischen dem Ansprechwiderstand (3) und dem Spannungsindikator (10) eine in Sperrichtung geschaltete Koppeldiode (16) vorgesehen ist.

9. Elektronisches Schaltgerät nach einem der Ansprüche 3 bis 8, dadurch gekennzeichnet, daß dem zweiten Verzögerungskondensator (9) bzw. dem Spannungsindikatorkondensator (12) ein Potentialausgangswiderstand (17, 18) parallelgeschaltet ist bzw. in Reihe mit dem Spannungsindikatorwiderstand (11) ein Potentialausgangswiderstand (19) geschaltet ist.

10. Elektronisches Schaltgerät nach einem der Ansprüche 1 bis 9, wobei als elektronischer Schalter ein Transistor vorgesehen ist und der Ansprechwiderstand im Emitterkreis des elektronischen Schalters liegt,

- 2 -

dadurch gekennzeichnet, daß der Reihenschaltung aus der Basis-Emitter-Strecke (20) des elektronischen Schalters (1) und aus dem Ansprechwiderstand (3) eine Zenerdiode (21) parallelgeschaltet ist.

11. Elektronisches Schaltgerät nach einem der Ansprüche 1 bis 10, dadurch gekennzeichnet, daß dem Überlastungsschutz und dem Kurzschlußschutz jeweils ein invertierender Schmitt-Trigger (22, 23) nachgeschaltet sind, an den Ausgang (24) des dem Überlastungsschutz nachgeschalteten Schmitt-Triggers (22) und/oder an den Ausgang des dem Kurzschlußschutz nachgeschalteten Schmitt-Triggers ein drittes Verzögerungsglied (25) - Reihenschaltung aus einem dritten Verzögerungswiderstand (26) und einem dritten Verzögerungskondensator (27) - angeschlossen ist und der dritte Verzögerungskondensator (27) über jeweils eine in Durchlaßrichtung geschaltete Entladediode (28, 29) mit den Ausgängen (24, 30) der beiden Schmitt-Trigger (22, 23) verbunden ist.

12. Elektronisches Schaltgerät nach Anspruch 11, dadurch gekennzeichnet, daß dem dritten Verzögerungskondensator (27) ein Schmitt-Trigger (31) nachgeschaltet ist.

13. Elektronisches Schaltgerät nach einem der Ansprüche 1 bis 12, dadurch gekennzeichnet, daß der Anwesenheitsindikator bzw. der dem Anwesenheitsindikator nachgeschaltete Schaltverstärker einerseits und der Überlastungsschutz und der Kurzschlußschutz bzw. der dem dritten Verzögerungskondensator (27) nachgeschaltete Schmitt-Trigger (31) andererseits über ein UND-Glied (32) an die Steuerelektrode (33) des elektronischen Schalters (1) angeschlossen sind.

14. Elektronisches Schaltgerät nach Anspruch 13, dadurch gekennzeichnet, daß den Eingängen (35, 36) des UND-Gliedes (32) jeweils ein Schmitt-Trigger nachgeschaltet ist.

- 3 -

Fig.1

Fig.2

**Fig.3**

**Fig.4**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| A | US-A-4 329 730 (L.J. RYCZEK et al.)<br>* Figur 2, Positionen 18,16,Q2,R8,R7,C4; Spalte 2, Zeilen 9-12,54-67 * | 1 | H 03 K 17/945<br>H 03 K 17/08<br>H 02 H 3/087 |
| | --- | | |
| A | PATENT ABSTRACTS OF JAPAN, Band 4, Nr. 28 (E-1)[510], 8. März 1980, Seite 3 E 1; & JP - A - 55 609 (TATEISHI DENKI K.K.) 07.01.1980<br>* Figur * | 1 | |
| | --- | | |
| A | GB-A-2 020 504 (LUCAS INDUSTRIES LTD.)<br>* Figur 2; Seite 2, Zeilen 12-25 * | | |
| | --- | | RECHERCHIERTE SACHGEBIETE (Int. Cl.4) |
| A | DE-A-3 238 899 (R. BOSCH GMBH)<br>* Figur 1; Seiten 7,8 * | | H 02 H 3/06<br>H 02 H 3/08 |
| | --- | | H 02 H 3/087 |
| A | DE-A-3 116 846 (SIEMENS AG)<br>* Figur 1 * | | H 02 H 3/093<br>H 02 H 7/20<br>H 03 K 17/08 |
| | --- | | H 03 K 17/945 |
| A | DE-A-3 111 659 (KASTL KG ELECTRONIC)<br>* Figur 2 * | | H 03 K 17/95<br>H 03 K 17/955 |
| | --- | | |
| D,A | DE-B-2 149 063 (W. KLASCHKA) | | |
| | ---     -/- | | |

Der vorliegende Recherchenbericht wurde für alle Patentansprüche erstellt.

| Recherchenort<br>BERLIN | Abschlußdatum der Recherche<br>07-08-1985 | Prüfer<br>ARENDT M |
|---|---|---|

Europäisches
Patentamt

**EUROPÄISCHER RECHERCHENBERICHT**

0166125
Nummer der Anmeldung

EP 85 10 5396

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | DE-A-2 331 732  (R. BUCK) | | |
| | --- | | |
| D,A | DE-B-2 515 654  (W. KLASCHKA) | | |
| | ----- | | |

RECHERCHIERTE SACHGEBIETE (Int. Cl.4)

Der vorliegende Recherchenbericht wurde für alle Patentansprüche erstellt.

| Recherchenort BERLIN | Abschlußdatum der Recherche 07-08-1985 | Prüfer ARENDT M |
|---|---|---|

KATEGORIE DER GENANNTEN DOKUMENTEN
X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, überein-
    stimmendes Dokument

EPA Form 1503 03 82